Europäisches Patentamt

European Patent Office

Office européen des brevets

(19)

(11) Numéro de publication : **0 285 478 B1**

## FASCICULE DE BREVET EUROPEEN

(12)

(45) Date de publication du fascicule du brevet :
**20.02.91 Bulletin 91/08**

(51) Int. Cl.⁵ : **G01P 21/02, H03K 5/153**

(21) Numéro de dépôt : **88400562.0**

(22) Date de dépôt : **10.03.88**

(54) Circuit convertisseur de signaux analogiques en signaux logiques.

(30) Priorité : **20.03.87 FR 8703876**

(43) Date de publication de la demande :
**05.10.88 Bulletin 88/40**

(45) Mention de la délivrance du brevet :
**20.02.91 Bulletin 91/08**

(84) Etats contractants désignés :
**DE GB IT SE**

(56) Documents cités :
**DE-A- 2 556 257**

(56) Documents cités :
**US-A- 3 763 436**
**US-A- 3 801 830**
**US-A- 3 882 474**
**US-A- 4 001 604**
**US-A- 4 074 325**
**US-A- 4 575 664**

(73) Titulaire : **Siemens Aktiengesellschaft**
**Wittelsbacherplatz 2**
**D-8000 München 2 (DE)**

(72) Inventeur : **Suquet, Michel**
**40 rue Saint-Périer, Villeneuve Tolosane**
**F-31270 Cugnaux (FR)**

## Description

La présente invention est relative à un circuit convertisseur de signaux analogiques en signaux logiques et, plus particulièrement, à un tel circuit équipé de moyens d'évaluation du niveau du signal analogique fourni au circuit.

Pour la conversion d'un signal périodique alternatif en un signal logique constitué, par exemple, d'impulsions de tension électrique de niveau prédéterminé, on utilise couramment un comparateur dont la sortie présente l'un ou l'autre de deux états logiques en fonction du signe de la différence de potentiel appliquée entre les entrées du comparateur, différence de potentiel liée aux variations du signal périodique à convertir. On peut ainsi convertir des alternances du signal périodique en impulsions acceptables par des circuits numériques, pour des besoins de comptage par exemple.

C'est notamment le cas lorsque le signal périodique est constitué par le signal de sortie d'un capteur à reluctance variable associé à un disque denté tournant avec un arbre, ce signal de sortie présentant l'allure d'un signal sinusoïdal de fréquence significative de la vitesse de rotation de l'arbre. Pour transmettre cette vitesse à des moyens numériques réalisant des calculs à partir de celle-ci, on forme une suite d'impulsions associées à des alternances du signal, le comptage de ces impulsions par les moyens numériques permettant d'atteindre la vitesse de l'arbre.

L'amplitude du signal quasi sinusoïdal fourni par un capteur à reluctance variable est fonction de la vitesse de rotation de l'arbre et aussi de la largeur d'entrefer, c'est à dire de la distance qui sépare les dents du disque et le capteur, distance fixée par un réglage mécanique. Quand cette distance s'accroît, l'amplitude du signal décroît, à vitesse constante. Cette décroissance peut rendre le signal inexploitable. Or, dans certains environnements difficiles, tel que celui du moteur d'un véhicule automobile, des vibrations peuvent modifier le réglage de cette distance, par desserrage des moyens de fixation du capteur par exemple. Il convient donc de pouvoir vérifier périodiquement que la largeur d'entrefer n'est pas telle qu'elle empêche la fourniture d'un signal exploitable par le capteur. Une vérification par des moyens mécaniques de mesure classiques tels que jauges, cales d'espacement, etc. n'est pas praticable dans l'application mentionnée ci-dessus du fait de la difficulté d'accès au capteur et du caractère périodique et fréquent de cette vérification, qui rendrait celle-ci coûteuse.

En outre, l'affaiblissement du signal du capteur peut aussi résulter d'un court-circuit partiel de son bobinage électrique. Il convient que les conséquences d'un tel dommage puissent être perçues par une vérification périodique de l'amplitude du signal fourni par le capteur.

La présente invention a donc pour but de permettre de telles vérifications par des moyens purement électroniques, propres à être mis en oeuvre automatiquement par des moyens numériques de calcul exploitant l'information de vitesse contenue dans le signal de sortie du capteur.

On atteint ce but de l'invention avec un circuit convertisseur d'un signal électrique analogique alternatif en un signal logique, comprenant un comparateur présentant des première et deuxième entrées entre lesquelles le signal analogique est appliqué différentiellement, une source de tension continue de polarisation connectée par une borne à ces première et deuxième entrées par l'intermédiaire de première et deuxième résistances, respectivement, et des moyens pour faire varier sélectivement la sensibilité du circuit, caractérisé en ce que ces moyens comprennent une source de courant sélectivement connectable entre la première entrée du comparateur et l'autre borne de la source de tension, et un organe de commutation pour commander la mise en circuit de la source de courant et déclencher ainsi l'apparition d'une tension de décalage prédéterminée aux bornes de la première résistance, de manière à déterminer l'amplitude de la tension du signal analogique qui déclenche la production d'impulsions logiques à la sortie du comparateur.

Au dessin annexé, donné seulement à titre d'exemple :
- la Fig. 1 est un schéma du circuit convertisseur suivant l'invention ;
- la Fig. 2 représente des graphes utiles à la compréhension du fonctionement du convertisseur suivant l'invention ;
- la Fig. 3 représente un premier mode de réalisation du convertisseur de la Fig. 1 ; et
- la Fig. 4 représente une variante de la source de courant utilisée dans le circuit suivant l'invention qui améliore la stabilité du circuit.

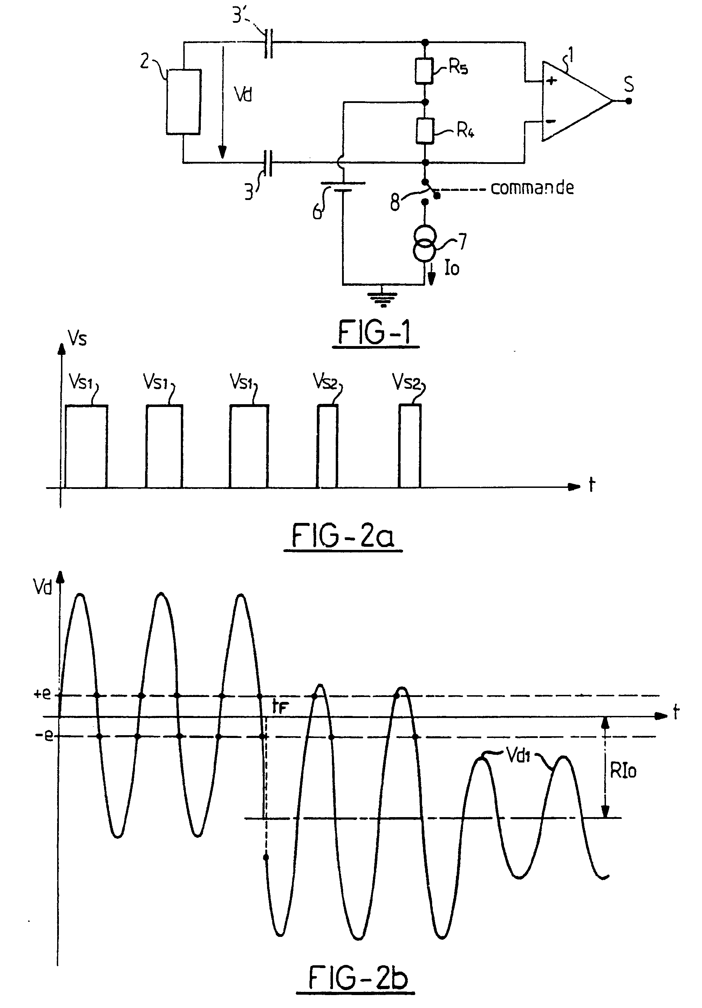

On se réfère aux Figs 1 et 2 où il apparaît que le circuit convertisseur de la Fig. 1 comprend essentiellement un comparateur 1 présentant une première entrée (–) inverseuse et une deuxième entrée (+) non inverseuse. Une source 2 fournit un signal analogique appliqué différentiellement entre les entrées du comparateur par l'intermédiaire de condensateurs 3, 3'. Dans une application particulière du circuit suivant l'invention, la source 2 est constituée par un capteur magnétique à reluctance variable du type utilisé dans un véhicule automobile pour détecter la vitesse de rotation d'une roue ou de l'arbre de sortie du moteur. Le capteur est alors associé à un disque denté tournant avec l'axe de la roue ou l'arbre du moteur, le capteur étant fixé à proximité de la trajectoire des dents du disque. Le défilement des dents devant le capteur fait varier la reluctance de son circuit magnétique du fait de la variation de la largeur de l'entrefer disque-capteur due à la découpe des dents du disque. Cette variation de reluctance induit dans un bobinage électrique du capteur un signal de tension quasi sinusoïdal dont la fréquence est égale à celle du défilement des dents devant le capteur. Cette fréquence est évidemment liée à la vitesse de rotation de l'arbre, qui peut ainsi être atteinte.

Le signal quasi sinusoïdal fourni par le capteur est impropre à une exploitation par des moyens numériques de calcul tels que ceux que l'on utilise dans les gouverneurs de boîte de vitesses automatique ou dans les dispositifs d'antiblocage de roues. Il convient donc de convertir ce signal analogique en un signal logique permettant de dériver la fréquence du signal d'un simple comptage d'impulsions électriques convenablement conformées. Pour ce faire le comparateur 1 produit à sa sortie S, classiquement, des impulsions de tension électrique $V_s$ rectangulaires d'amplitude déterminée (voir Fig. 2a) synchrones des alternances positives du signal quasi sinusoïdal transmis par les condensateurs 3, 3' entre les entrées du comparateur, à partir du signal de tension $V_d$ formé par le capteur 2 (voir Fig. 2b). Pour obtenir les impulsions rectangulaires $V_s$, il suffit que le signal $V_d$ passe par les niveaux (+e) et (−e) qui correspondent aux basculements de la sortie du comparateur 1, dans le cas où celui-ci présente de l'hystérésis. Les impulsions rectangulaires $V_{s1}$ de la Fig. 2a correspondent à des alternances du signal analogique $V_d$ dont l'amplitude dépasse très largement les niveaux (+e) et (−e). Les commutations du comparateur 1 sont alors franches.

Pour les raisons développées plus haut, suivant l'invention, on souhaite vérifier que l'amplitude du signal fourni par le capteur 2 est telle qu'elle correspond à un entrefer correct et/ou à un bobinage sans court-circuit partiel, ceci afin d'être assuré de la validité des informations de vitesse fournies par le capteur d'une part, et afin de contrôler l'état de fonctionnement du capteur pour réaliser éventuellement un entretien préventif avant l'apparition d'une panne complète, d'autre part.

Suivant la présente invention, on équipe à cet effet le circuit convertisseur de moyens pour faire varier sélectivement la sensibilité du circuit. Des première et deuxième résistances $R_4$, $R_5$ respectivement, de même valeur R, sont installées en série entre les entrées du comparateur 1, une source de tension continue 6 de polarisation étant connectée entre le point commun aux résistances $R_4$, $R_5$ et la masse. Les moyens de réglage de la sensibilité du circuit comprennent une source de courant 7 et un organe de commutation 8 connectés en série avec une des résistances $R_4$, $R_5$, entre les bornes de la source de tension 6. Dans le circuit de la Fig. 1, c'est la résistance $R_4$ connectée à l'entrée inverseuse du comparateur qui est placée en série avec la source de courant 7, par l'intermédiaire de l'organe de commutation 8. Ainsi quand cet organe est fermé, la source 7 fait circuler un courant $I_o$ dans la résistance $R_4$, ce qui fait apparaître une chute de tension $RI_o$ de décalage aux bornes de cette résistance. Cette chute de tension abaisse d'autant le potentiel appliqué à l'entrée inverseuse du comparateur 1.

Si on se reporte maintenant au graphe de la Fig. 2b, il apparaît que cette tension de décalage $RI_o$ modifie la position du signal $V_d$ par rapport aux seuils (+e) et (−e) de commutation du comparateur 1. Ainsi, l'organe de commutation 8 étant fermé à l'instant $t_F$ pour mettre en circuit la source de courant 7, il apparaît que le signal quasi sinusoïdal fourni par le capteur doit dépasser en amplitude les valeurs $RI_o$ +/−e pour passer par les seuils de commutation du capteur et provoquer ainsi l'apparition d'impulsions $V_{s2}$ à la sortie du comparateur 1.

Si, au contraire, des alternances $V_{d1}$ (Fig. 2b) du signal $V_d$ n'atteignent pas ces valeurs d'amplitude, il n'y aura pas génération d'impulsions $V_s$. On conçoit donc que l'on peut comparer l'amplitude réelle du signal $V_d$ à la valeur $RI_o$ que l'on peut ajuster à un niveau prédéterminé par réglage du courant $I_o$ dans la résistance $R_4$.

Suivant l'invention, on fait application du circuit ci-dessus à l'établissement d'un diagnostic relatif à l'état de fonctionnement d'un capteur à reluctance variable installé dans un véhicule automobile, par exemple, pour fournir un signal quasi sinusoïdal présentant une fréquence qui est fonction de la vitesse de rotation d'une roue ou d'un arbre moteur. Comme on l'a vu plus haut, l'amplitude du signal fourni par un tel capteur dépend non seulement de la largeur de l'entrefer capteur/disque denté mais aussi de la vitesse de rotation du disque et donc de la roue ou de l'arbre surveillé. Pour diagnostiquer l'état de fonctionnement du capteur il convient d'éliminer l'influence de la vitesse sur l'amplitude du signal fourni. La vérification doit alors s'opérer à une vitesse prédéterminée. Sinon une correction fonction de la vitesse doit être appliquée à la valeur $RI_o$ qui constitue la référence de comparaison pour l'amplitude du signal $V_d$.

Pour réaliser un diagnostic, on déclenche la conduction de l'organe de commutation 8, constitué par exemple par un transistor commandé par sa base. Le signal de commande de l'organe 8 peut être fourni par les moyens de calcul qui exploitent le signal formé par le capteur 2, tels qu'un gouverneur électronique de boîte de vitesses ou un calculateur de dispositif d'antiblocage de roues par exemple. L'instant du test peut être déterminé par les moyens de calcul eux-mêmes, en préparation d'une action qui tient compte de la validité des informations de vitesse délivrées par le capteur. Les moyens de calcul lancent le test à une vitesse prédéterminée du mobile surveillé, ou tiennent compte de sa vitesse à l'instant du test.

La conduction de l'organe 8 met en circuit la source de courant provoquant ainsi l'apparition d'une chute de tension $RI_o$ aux bornes de la résistance $R_4$.

Comme on l'a vu plus haut, si le comparateur continue à fournir des impulsions aux moyens de calcul, c'est que l'amplitude du signal délivré par le capteur dépasse les seuils $RI_o$ +/–e, amplitude qui est ajustée pour correspondre à un signal fourni par un capteur dont le bobinage n'est pas affecté par un court-circuit partiel ou par un dépassement de la largeur d'entrefer nominale.

Dans le cas contraire, c'est à dire si les moyens de calcul détectent que la sortie S du comparateur ne fournit plus d'impulsions, le diagnostic est que le capteur est affecté d'un défaut de fonctionnement et qu'il faut alors prévoir une révision préventive de celui-ci. On peut aussi comparer l'amplitude du signal fourni par le capteur à plusieurs niveaux $RI_o$ en agissant sur la valeur $I_o$, par exemple, pour réaliser ainsi une véritable mesure de cette amplitude. Plusieurs réactions différentes peuvent être mises en oeuvre en fonction de la valeur mesurée, outre celles citées plus haut. Si, par exemple, le niveau du signal fourni par le capteur est considéré comme trop faible pour être distingué du bruit affectant le signal, les moyens de calcul peuvent faire sortir des calculs la vitesse telle que mesurée à partir du capteur défectueux, pour éviter qu'une valeur erronée de cette vitesse ne soit prise en compte dans les calculs. Le système d'antiblocage ou le gouverneur de boîte de vitesses peuvent même être entièrement mis hors service et remplacés par une commande classique réalisée par le conducteur lui-même.

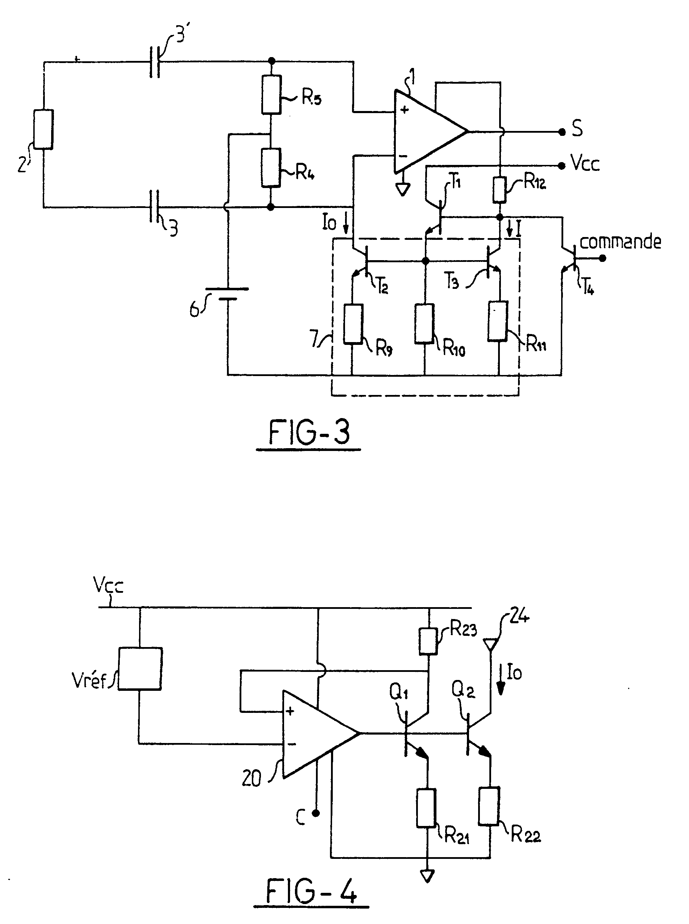

On a représenté à la Fig. 3 un mode de réalisation particulier du circuit convertisseur suivant l'invention, dans lequel la source de courant 7 est réalisée avec un montage de transistors en miroirs de courant. Sur cette figure, on a utilisé les mêmes références que sur la Fig. 1 pour désigner des composants similaires.

La source de courant 7 est constituée de deux transistors NPN $T_2$ et $T_3$ montés en miroirs de courant, leur base commune étant chargée par une résistance $R_{10}$, alors que des résistances $R_9$ et $R_{11}$ chargent les émetteurs des transistors $T_2$ et $T_3$ respectivement. On choisit des transistors $T_2$ et $T_3$ identiques et des valeurs égales pour les résistances $R_9$ et $R_{11}$. Dans ces conditions, le passage d'un courant I dans le circuit émetteur-collecteur du transistor $T_3$ est reflété par le passage d'un courant $I_o$ de même valeur dans le circuit émetteur-collecteur du transistor $T_2$, ce courant $I_o$ établissant une chute de tension $RI_o$ dans la résistance $R_4$.

On remarquera que l'impédance d'entrée élevée de la source 7 empêche que celle-ci ne perturbe le signal fourni par le capteur quand la source 7 ne débite pas de courant. Par ailleurs le couplage capacitif du capteur 2 aux entrées du comparateur 1 permet d'isoler, suivant l'invention, le capteur 2 de la source de courant continu 7, isolation qui évite le court-circuit du décalage de tension appliqué aux entrées du comparateur.

La base commune aux transistors $T_2$ et $T_3$ est commandée par le circuit émetteur-collecteur d'un transistor NPN $T_1$ dont la base est reliée au point commun à une résistance de charge $R_{12}$ du collecteur du transistor $T_3$ et au collecteur d'un transistor NPN $T_4$ dont l'émetteur est à la masse. Le collecteur du transistor $T_1$ et l'autre borne de la résistance $R_{12}$ sont connectés à une source de tension d'alimentation $V_{cc}$.

La conduction des transistors $T_2$ et $T_3$ est déclenchée par un signal de commande de diagnostic envoyé sur la base du transistor $T_4$ qui commande lui-même le transistor $T_1$ par l'intermédiaire de la base de ce dernier. Des courants I et $I_o$ circulent alors dans les circuits émetteur-collecteur des transistors $T_2$ et $T_3$ montés en miroirs de courant. L'intensité de ces courants est donnée par la formule suivante :

$$I_o = I = (V_{cc} - 2\,V_{be})/(R_{11} + R_{12}) \quad (1)$$

le terme $2\,V_{be}$ correspondant aux chutes de tension émetteur-base des transistors $T_1$ et $T_3$.

Le courant $I_o$ crée ainsi la chute de tension $RI_o$ aux bornes de la résistance $R_4$, chute de tension exploitée par le circuit suivant l'invention pour établir un diagnostic sur le signal formé par le capteur 2 et, par là, sur le fonctionnement du capteur, en fonction de la production ou de la non production d'impulsions de sortie $V_s$ par le comparateur 1. La formule (1) ci-dessus fait apparaître que le courant $I_o$ qui détermine la chute de tension $RI_o$ peut être sujet à des variations dues à des fluctuations de la tension $V_{cc}$ d'alimentation, variations courantes dans un véhicule automobile, ou dues à des variations de température qui influencent la valeur de la chute de tension émetteur-base $V_{be}$ du transistor $T_3$. On peut souhaiter accroître la précision du diagnostic en disposant d'une source de courant mieux protégée de telles variations que celle utilisée dans le circuit de la Fig. 3.

A cet effet, suivant l'invention, on peut utiliser la source de courant représentée à la Fig. 4 qui est caractérisée par une meilleure immunité vis-à-vis des variations de la tension d'alimentation $V_{cc}$ et des variations de température.

Cette source de courant comprend un amplificateur opérationnel programmable 20 monté en comparateur, dont la sortie commande la base commune de transistors NPN $Q_1$ et $Q_2$, (montés en miroirs de courant). Des résistances $R_{21}$ et $R_{22}$ sont montées entre les émetteurs des transistors $Q_1$ et $Q_2$, respectivement, et la masse. Une résistance $R_{23}$ est montée entre une alimentation $V_{cc}$ et le collecteur du transistor $Q_1$. L'entrée positive de l'amplificateur opérationnel est connectée au collecteur du transistor $Q_1$ tandis que son entrée négative est connectée à une source de tension de référence $V_{ref}$, elle-même reliée à l'alimentation $V_{cc}$. La source de courant est reliée au circuit convertisseur suivant l'invention par le circuit collecteur-émetteur du transistor $Q_2$, connecté en 24

à l'entrée négative du comparateur.

Cette source de courant est connectée au circuit convertisseur suivant l'invention par un signal appliqué à l'entrée de commande C de l'amplificateur 20, entrée qui joue alors le rôle d'organe de commutation, quand un diagnostic est demandé. Il en résulte la mise en conduction des transistors $Q_1$ et $Q_2$ et le passage des courants I et $I_o$ dans les circuits émetteur-collecteur des transistors $Q_1$ et $Q_2$. Suivant l'invention, on choisit pour cette source des transistors $Q_1$ et $Q_2$ identiques et des résistances $R_{21}$ et $R_{22}$ identiques. Les chutes de tension émetteur-base $V_{be}$ dans les deux transistors sont alors identiques et toute variation de cette chute de tension due à une variation de température est corrigée par bouclage du point commun à la résistance $R_{23}$ et au collecteur du transistor $Q_1$ sur l'entrée positive de l'amplificateur 20. De même toute fluctuation de la tension d'alimentation $V_{cc}$ est corrigée par cette même boucle. La précision de la source de courant de la Fig. 4 est rendue ainsi bien meilleure que celle de la source de courant 7 de la Fig. 3, qui peut cependant suffire dans les applications où une grande précision n'est pas exigée.

Comme on l'a mentionné plus haut, le circuit suivant l'invention peut être adapté à une véritable mesure de l'amplitude du signal délivré par le capteur, et non pas seulement à une simple comparaison de l'amplitude de ce signal à une valeur de référence. A cet effet on modifie, par exemple, le circuit de la Fig. 4 de manière que le générateur de tension de référence $V_{ref}$ soit réglable à plusieurs niveaux de tension distincts. Ce générateur peut prendre la forme d'un convertisseur numérique-analogique commandé, par exemple, par les moyens de calcul exploitant le signal du capteur. On atteint l'amplitude A de ce signal en réalisant plusieurs tests de niveaux successifs et en identifiant la valeur A de $V_{ref}$ telle que le comparateur fournisse un signal de sortie pour $V_{ref} = A-\varepsilon$ et n'en fournisse pas pour $V_{ref} = A+\varepsilon$, $\varepsilon$ étant le pas des niveaux de comparaison, qui donne la précision de la mesure.

Le comparateur utilisé dans le circuit suivant l'invention peut être constitué par un amplificateur opérationnel fonctionnant en saturation. Il peut présenter ou non de l'hystérésis. On préfère cependant utiliser un comparateur à hystérésis (voir Fig. 2) pour éliminer certains bruits affectant le signal de sortie du capteur.

Ainsi, le circuit convertisseur suivant l'invention est-il équipé de moyens permettant de faire varier la sensibilité du circuit pour des besoins de diagnostic sur l'amplitude d'un signal quasi sinusoïdal. Cette amplitude peut être comparée à un seuil prédéterminé ou bien à une suite de niveaux si on souhaite atteindre une véritable mesure de l'amplitude du signal. L'invention trouve application à la conversion d'un signal analogique en un signal logique et, plus particulièrement, au traitement du signal délivré par un capteur magnétique de vitesse à reluctance variable, sans que cette application soit limitative. L'invention s'étend en effet à l'établissement d'un diagnostic ou d'une mesure sur l'amplitude de tout signal analogique périodique traité par un circuit convertisseur de ce signal en signaux logiques, par modification commandée de la sensibilité du circuit.

## Revendications

1. Circuit convertisseur d'un signal électrique analogique alternatif en un signal logique, comprenant un comparateur (1) présentant des première et deuxième entrées entre lesquelles le signal analogique est appliqué différentiellement, une source de tension (6) continue de polarisation connectée par une première borne à ces première et deuxième entrées par l'intermédiaire d'une première ($R_4$) et deuxième ($R_5$) résistance respectivement, et des moyens pour faire varier sélectivement la sensibilité du circuit, caractérisé en ce que ces moyens comprennent une source de courant (7) sélectivement connectable entre la première entrée du comparateur et la deuxième borne de la source de tension, et un organe de commutation (8) pour commander la mise en circuit de la source de courant (7) et déclencher ainsi l'apparition d'une tension de décalage prédéterminée aux bornes de la première résistance ($R_4$), de manière à déterminer l'amplitude de la tension du signal analogique qui déclenche la production d'impulsions logiques à la sortie du comparateur.

2. Circuit conforme à la revendication 1, caractérisé en ce que chacune des deux entrées du comparateur est couplée capacitivement à une borne correspondante d'une source (2) délivrant le signal analogique.

3. Circuit conforme à l'une quelconque des revendications 1 et 2, caractérisé en ce que la source de courant (7) est constituée par deux transistors ($T_2$, $T_3$) montés en miroirs de courant, le circuit collecteur-émetteur d'un ($T_2$) des transistors étant connecté entre la première entrée du comparateur et la masse, la base commune des deux transistors étant commandée par un transistor ($T_1$) lui-même commandé par un transistor ($T_4$) constituant l'organe de commutation de la source de courant, pour déterminer le passage d'un courant ($I_o$) dans le circuit collecteur-émetteur du transistor ($T_2$), ce courant ($I_o$) établissant une tension de décalage aux bornes de la première résistance ($R_4$).

4. Circuit conforme à l'une quelconque des revendications 1 et 2, caractérisé en ce que la source de courant (7) comprend un amplificateur opérationnel (20) dont la sortie commande des transistors ($Q_1$, $Q_2$) montés en miroirs de courant, le circuit collecteur-émetteur d'un ($Q_2$) des transistors étant connecté entre la première entrée du comparateur et la masse et le courant ($I_o$) passant dans ce circuit établissant une chute de tension de décalage aux bornes de la première résistance ($R_4$), une entrée de l'amplificateur opérationnel étant alimentée par une source de tension de référence ($V_{ref}$) tandis que l'autre entrée est connectée au collecteur du transistor ($Q_1$) pour compenser les effets de toute variation de la tension d'alimentation du circuit ou de la température sur le signal de sortie de l'amplificateur opérationnel.

5. Circuit conforme à la revendication 4, caractérisé en ce que l'amplificateur opérationnel (20) est programmable et comprend une entrée de commande (C) qui constitue l'organe de commutation de la source de courant.

6. Circuit conforme à l'une quelconque des revendications 4 et 5, caractérisé en ce que la source de tension de référence ($V_{ref}$) est réglable pour établir la sensibilité du circuit à plusieurs niveaux différents d'une gamme de tels niveaux et déduire de la production et de la non production d'un signal logique à la sortie du comparateur pour deux niveaux successifs de la gamme, respectivement, une mesure de l'amplitude du signal analogique traité.

7. Circuit conforme à la revendication 6, caractérisé en ce que la source de tension de référence réglable est constituée par un convertisseur numérique-analogique.

8. Application du circuit convertisseur suivant l'une quelconque des revendications précédentes, à l'établissement d'un diagnostic d'état de fonctionnement d'un capteur magnétique à reluctance variable délivrant un signal de tension quasi sinusoïdal utilisé pour mesurer la vitesse d'un mobile, application caractérisée par le fait que les moyens pour faire varier la sensibilité du circuit sont mis en oeuvre de manière que la production ou la non production de signaux à la sortie du comparateur soit significative de la position de l'amplitude du signal du capteur par rapport à la tension de décalage établie par les moyens de réglage de la sensibilité et qu'une amplitude de signal inférieure à cette tension soit alors interprétable comme un défaut de fonctionnement du capteur.

9. Application conforme à la revendication 8, caractérisée en ce que le diagnostic est établi alors que la mobile se déplace à une vitesse prédéterminée.

10. Application conforme à la revendication 8, caractérisée en ce que les moyens pour faire varier la sensibilité du circuit sont sensibles à la vitesse du mobile au moment du diagnostic.

11. Application conforme à la revendication 8, caractérisée en ce que l'amplitude du signal délivré par le capteur est mesurée par comparaison à plusieurs niveaux de tension de décalage successifs établissant autant de niveaux distincts de sensibilité du circuit.

12. Application conforme à l'une quelconque des revendications 8 à 11, caractérisée en ce que le signal délivré par le capteur est significatif de la vitesse de rotation d'un arbre formant partie d'un véhicule automobile.

## Ansprüche

1. Wandlerschaltung zum Umwandeln eines elektrischen analogen Wechselstromsignals in ein digitales Signal, mit einem Vergleichsglied (1), das einen ersten und einen zweiten Eingang aufweist, zwischen denen das analoge Signal differentiell anlegbar ist, einer Gleichspannungsquelle (6), die mit einer ersten Klemme über einen ersten bzw. einen zweiten Widerstand an dem ersten und zweiten Eingang angeschlossen ist, und mit Mitteln zum wahlweisen Ändern der Empfindlich-keit der Schaltung, dadurch gekennzeichnet, daß diese Mittel umfassen: eine Stromquelle (7), die wahlweise zwischen den ersten Eingang des Vergleichsgliedes und die zweite Klemme der Spannungsquelle schaltbar ist, und eine Schalteinrichtung (8) zum Steuern der Zuschaltung der Stromquelle (7) und somit zum Auslösen einer vorgegebenen Verschiebespannung an den Klemmen des ersten Widerstandes ($R_4$), um die Amplitude der Spannung des analogen Signals zu bestimmen, das die Erzeugung von digitalen Impulsen am Ausgang des Vergleichsgliedes auslöst.

2. Schaltung nach Anspruch 1, dadurch gekennzeichnet, daß jeder der beiden Eingänge des Vergleichsgliedes kapazitiv an eine entsprechende Klemme einer Analogsignalquelle (2) angeschlossen ist.

3. Schaltung nach Anspruch 1 oder 2, dadurch gekennzeichnet, daß die Stromquelle (7) von zwei spiegelbildlich geschalteten Transistoren ($T_2$, $T_3$) gebildet wird, wobei der Kollektor-Emitter-Pfad eines ($T_2$) der Transistoren zwischen den ersten Eingang des Vergleichsgliedes und Masse geschaltet ist, die gemeinsame Basis der beiden Transistoren von einem Transistor ($T_1$) gesteuert wird, der seinerseits von einem Transistor ($T_4$) gesteuert wird, welcher die Schalteinreichtung der Stromquelle bildet, um den Durchgang eines Stromes ($I_o$) durch den Kollektor-Emitter-Pfad des Transistors ($T_2$) zu bestimmen, wobei dieser Strom ($I_o$) eine Verschiebespannung an den Klemmen des ersten Widerstandes ($R_4$) erzeugt.

4. Schaltung nach Anspruch 1 oder 2, dadurch gekennzeichnet, daß die Stromquelle (7) einen Operationsverstärker (20) aufweist, dessen Ausgang spiegelbildlich geschaltete Transistoren ($Q_1$) steuert, wobei der Kollektor-Emitter-Pfad eines der Trasnsistoren ($Q_2$) zwischen den ersten Eingang des Vergleichsgliedes und Masse geschaltet ist und der durch diesen Pfad fließende Strom einen Abfall der Verschiebespannung an den Klemmen des ersten Widerstandes ($R_4$) erzeugt, wobei ein Eingang des Operationsverstärkers von einer Bezugsspannungsquelle (V$_{ref}$) gespeist wird, während der andere Eingang mit dem Kollektor des Transistors (Q$_1$) verbunden ist, um die Auswirkungen einer Änderung der Versorgungsspannung der Schaltung oder der Temperatur auf das Ausgangssignal des Operationsverstärkers zu kompensieren.

5. Schaltung nach Anspruch 4, dadurch gekennzeichnet, daß der Operationsverstärker (20) programmierbar ist und einen Steuereingang (C) aufweist, der die Schalteinrichtung der Stromquelle bildet.

6. Schaltung nach Anspruch 4 oder 5, dadurch gekennzeichnet, daß die Bezugsspannungsquelle (V$_{ref}$) regelbar ist, um die Empfindlichkeit der Schaltung auf mehrere unterschiedliche Pegel eines Bereiches solcher Pegel festzulegen, und abhängig von der Erzeugung bzw. Nicht-Erzeugung eines digitalen Signals am Ausgang des Vergleichsgliedes für zwei aufeinanderfolgende Pegel des Bereiches jeweils ein Maß für die Amplitude des verarbeiteten analogen Signals abzuleiten.

7. Schaltung nach Anspruch 6, dadurch gekennzeichnet, daß die regelbare Bezugsspannungsquelle von einem Digital-Analog-Wandler gebildet wird.

8. Anwendung der Wandlerschaltung nach einem der vorhergehenden Ansprüche auf das Erstellen einer Diagnose des Betriebszustandes eines magnetischen Fühlers veränderlicher Reluktanz, der ein quasi-sinusförmiges Signal abgibt, welches dazu benutzt wird, um die Geschwindigkeit eines Fahrzeuges zu messen, dadurch gekennzeichnet, daß die Mittel zum Ändern der Empfindlichkeit der Schaltung derart arbeiten, daß die Erzeugung oder Nicht-Erzeugung von Signalen am Ausgang des Vergleichsgliedes die Position der Amplitude des Signals des Fühlers bezüglich der von den Mitteln zum Ändern der Empfindlichkeit bestimmten Verschiebespannung anzeigt und daß eine Signalamplitude, die kleiner als diese Spannung ist, somit als ein Funktionsfehler des Fühlers erkennbar ist.

9. Anwendung nach Anspruch 8, dadurch gekennzeichnet, daß die Diagnose erstellt wird, während sich das Fahrzeug mit einer vorgegebenen Geschwindigkeit bewegt.

10. Anwendung nach Anspruch 8, dadurch gekennzeichnet, daß die Mittel zum Ändern der Empfindlichkeit der Schaltung auf die Geschwindigkeit des Fahrzeuges im Augenblick der Diagnose ansprechen.

11. Anwendung nach Anspruch 8, dadurch gekennzeichnet, daß die Amplitude des vom Fühler abgegebenen Signals durch einen Vergleich mehrerer aufeinanderfolgender Pegel der Verschiebespannung gemessen wird, wodurch verschiedene Empfindlichkeitspegel der Schaltung erzeugt werden.

12. Anwendung nach einem der Ansprüche 8 bis 11, dadurch gekennzeichnet, daß das von dem Fühler abgegebene Signal die Drehgeschwindigkeit einer Welle wiedergibt, die einen Teil eines Kraftfahrzeuges bildet.

## Claims

1. Circuit for converting an alternating analog electrical signal into a logic signal, comprising a comparator (1) having first and second inputs between which the analog signal is applied differentially, a DC bias voltage source (6) connected by one first terminal to these first and second inputs through first (R$_4$) and second (R$_5$) resistors respectively and means of causing the sensitivity of the circuit to vary selectively, characterized in that these means comprise a current source (7) selectively connectable between the first input of the comparator and the second terminal of the voltage source, and a switching device (8) for controlling the bringing into circuit of the current source (7) and thus triggering the appearance of a predetermined offset voltage at the terminals of the first resistor (R$_4$), in order to determine the amplitude of the voltage of the analog signal which triggers the production of logic pulses at the output of the comparator.

2. Circuit according to Claim 1, characterised in that each of the two inputs of the comparator is capacitively coupled to a corresponding terminal of a source (2) delivering the analog signal.

3. Circuit according to either of Claims 1 and 2, characterised in that the current source (7) is constituted by two transistors (T$_2$, T$_3$) connected as current mirrors, the collector-emitter circuit of one (T$_2$) of the transistors being connected between the first input of the comparator and ground, the common base of the two transistors being controlled by a transistor (T$_1$) itself controlled by a transistor (T$_4$) constituting the switching device of the current source, in order to determine the flow of a current (I$_0$), in the collectoremitter circuit of the transistor (T$_0$), this current (I$_0$) establishing an offset voltage at the terminals of the first resistor (R$_4$).

4. Circuit according to either of Claims 1 and 2, characterised in that the current source (7) comprises an operational amplifier (20) whose output controls transistors (Q$_1$, Q$_2$) connected as current mirrors, the collector-emitter circuit of one (Q$_2$) of the transistors being connected between the first input of the comparator and ground and the current (I$_0$) flowing in this circuit establishing an offset voltage drop at the terminals of the first resistor (R$_4$), one input of the operational amplifier being fed by a reference voltage source (V$_{ref}$) while the other input is connected to the collector of the transistor (Q$_1$) in order to compensate for the effects of any variation in the supply voltage of the circuit or of the temperature on the output signal of the operational amplifier.

5. Circuit according to Claim 4, characterised in that the operational amplifier (20) is programmable and comprises a control input (C) which constitutes the switching device of the current source.

6. Circuit according to either of Claims 4 and 5, characterised in that the reference voltage source (V$_{ref}$) is adjustable in order to set up the sensitivity of the circuit at several different levels over a range of such levels and to derive from the production and from the non-production respectively of a logic signal at the output of the comparator for two successive levels in the range, a measurement of the amplitude of the processed analog signal.

7. Circuit according to Claim 6, characterised in that the adjustable reference voltage source is constituted by a digital-analog converter.

8. Application of the converter circuit according to any of the preceding Claims to the carrying out of a diagnosis of the operating state of a variable reluctance magnetic sensor delivering a quasi-sinusoidal voltage signal used for measuring the speed of a moving object, an application characterised by the fact that the means of varying the sensitivity of the circuit are implemented in such a way that the production or non-production of signals at the output of the comparator indicate the position of the amplitude of the signal from the sensor with respect to the offset voltage set up by the means of adjusting the sensitivity and that a signal amplitude lower than this voltage can then be interpreted as an operational fault of the sensor.

9. Application according to Claim 8, characterised in that the diagnosis is carried out while the moving object is moving at a predetermined speed.

10. Application according to Claim 8, characterised in that the means of varying the sensitivity of the circuit are sensitive to the speed of the moving object at the moment of the diagnosis.

11. Application according to Claim 8, characterised in that the amplitude of the signal delivered by the sensor is measured by comparison with several successive levels of offset voltage setting up a similar number of separate sensitivity levels of the circuit.

12. Application according to any of Claims 8 to 11, characterised in that the signal delivered by the sensor represents the speed of rotation of a shaft forming part of a motor vehicle.

FIG-1

FIG-2a

FIG-2b

FIG-3

FIG-4